# DEMANDE DE BREVET EUROPEEN

(11) **EP 2 357 875 A1**
(43) Date de publication de la demande: **17.08.2011**
(21) Numéro de dépôt: 10305158.7
(22) Date de dépôt: 16.02.2010
(51) Int. Cl.: H05K 1/18, H01L 21/56, H01L 23/00, G06K 19/077

(54) **Procédé pour fabriquer un boîtier électronique**

(71) Demandeur: Gemalto SA, 92190 Meudon (FR)
(72) Inventeur: Dossetto, Lucile, 83270, SAINT CYR SUR MER (FR); Dubois, Béatrice, 13100, AIX EN PROVENCE (FR); Fidalgo, Jean-Christophe, 13420, GEMENOS (FR)

(57) **Abrégé**

L'invention concerne des procédés et systèmes pour fabriquer des boîtiers ou modules comportant un ou plusieurs éléments électroniques. De tels procédés et systèmes sont particulièrement efficaces et adaptables car ils mettent en oeuvre principalement des techniques de jets de matières isolantes ou conductrices.

## Description

L'invention concerne un système et un procédé pour fabriquer un boîtier électronique comportant une puce et/ou un composant électronique ainsi que le boîtier obtenu.

On peut trouver de tels boîtiers par exemple sous la forme de modules pour cartes à puce, de facteurs de forme tels que de petits objets électroniques de formats micro-SD *(Secure Digital* en langue anglaise), Micro-SIM *(Subscriber Identity Module* en langue anglaise) ou Plug-in SIM, Mini UICC *(Universal Integrated Circuit Card* en langue anglaise). On peut trouver en outre toute une gamme de boîtiers permettant le montage de composants en surface (CMS ou SMD) ainsi que des boîtiers de type BGA *(Ball Grid Array* en langue anglaise) comportant des billes de connexion.

L'invention concerne plus particulièrement, mais de manière non limitative, la fabrication d'objets électroniques portables sécurisés qui trouvent notamment leurs applications dans la santé, la banque, les télécommunications ou encore le contrôle d'identité.

Les techniques connues pour fabriquer de tels objets nécessitent un procédé parfois lent, complexe et peu adaptable.

A titre d'exemple, pour fabriquer un module pour une carte à puce, des étapes sont nécessaires parmi lesquelles on trouve principalement :
- une définition d'un rouleau de circuit imprimé spécifique ;
- une découpe mécanique dudit circuit imprimé ou gravure chimique pour définir une forme de contacts ;
- une découpe dans un diélectrique pour créer des puits de connexion ;
- un contre-collage du diélectrique sur le circuit imprimé ;
- une métallisation de plots de contacts ;
- un collage d'une ou plusieurs puces d'épaisseurs variables ;
- un câblage à l'aide de fils pour interconnecter lesdites puces et relier les points de contact ;
- un enrobage sous une résine de protection, etc.

Pour réaliser un objet électronique, il est par ailleurs nécessaire de reporter un module au sein d'une cavité prévue dans un corps en matière plastique par exemple. Y compris pour de tout petits objets, il est ainsi nécessaire de prévoir la création d'un corps en parallèle de la création d'un module puis un report de ce dernier dans ledit corps, etc.

L'ensemble de ces techniques nécessitent des outils dédiés et devant être adaptés à un module ou boîtier particulier. Pour maintenir une cadence de fabrication acceptable, les machines exigent une grande précision et sont donc coûteuses. A titre d'exemple, une opération de câblage est particulièrement problématique : de quelques fils pour des produits courants, à près d'une centaine de fils pour des produits complexes, généralement d'or ou d'aluminium, sont parfois nécessaires à la réalisation d'un module. De même une opération de collage peut être sensible en particulier si une pluralité de composants ou puces distinct(e)s sont nécessaires pour réaliser un module. Un collage homogène de puces d'épaisseurs variées ou de composants électroniques - tels que des capacités par exemple - peut être complexe pour prévenir la formation de bulles d'air, emprisonnées sous certaines puces, qui viendraient fragiliser le module. Le temps de fabrication peut ainsi être pénalisant et altérer le coût global de fabrication d'un boîtier.

L'invention permet de répondre à l'ensemble des inconvénients soulevés par les solutions connues. Elle permet notamment d'utiliser un minimum d'équipements et d'éléments pour constituer un boîtier. L'invention permet de maintenir un haut niveau d'exigences en matière de protection des puces et des éléments électroniques. L'invention simplifie également l'étape de connexion et supprime toute une série d'opérations coûteuses ou grevant le temps de fabrication.

L'invention permet de mettre en oeuvre un procédé de fabrication fiable, rapide et adaptable. L'invention permet en outre la réalisation directe d'un facteur de forme en une seule série opérations.

A cette fin, il est prévu un procédé pour fabriquer un boîtier électronique comportant une puce dont une face est active. Un tel procédé comporte :
- une étape pour déposer une puce, face active vers le bas, sur un support adhésif tracté ;
- une étape de moulage d'une résine pour enrober la puce sur son support adhésif, l'ensemble puce et résine formant un îlot
- une étape de retournement dudit îlot pour que la puce de ce dernier ait sa face active exposée ;
- une étape pour appliquer une matière conductrice sur l'îlot retourné, pour matérialiser une plage de contact reliant un plot de contact de la puce au monde extérieur.

Selon un mode de réalisation préférée, un îlot peut comporter une pluralité de puces et/ou de composants électroniques. L'étape pour appliquer une matière conductrice peut consister en outre à interconnecter lesdites puces et/ou composants électroniques.

L'invention prévoit qu'un tel procédé puisse comporter une étape - préalable à l'étape pour appliquer une matière conductrice - pour appliquer une couche isolante sur l'îlot retourné, à l'exception d'un ou plusieurs plots de contact d'une puce de l'îlot.

En variante, le procédé peut comporter une étape - préalable à l'étape pour appliquer une matière conductrice - pour éliminer une partie d'une couche isolante au niveau d'un plot de contact d'une puce de l'îlot, ladite couche isolante étant préalablement transférée du support adhésif à l'îlot lors des étapes pour déposer la puce et pour mouler la résine.

Quel que soit le mode de réalisation, un procédé selon l'invention peut comporter une étape - subséquente à l'étape pour appliquer une matière conductrice - pour appliquer une couche isolante sur l'îlot retourné à l'exception d'une plage de contact de l'îlot voire une étape de découpe de l'îlot pour adapter les dimensions de ce dernier.

L'invention prévoit également un système pour fabriquer un boîtier électronique - comportant une puce dont une face est active -, ledit système comportant :
- des moyens pour déposer une puce - face active vers le bas - sur un support adhésif tracté;
- des moyens pour mouler une résine pour enrober la puce sur son support adhésif, l'ensemble puce et résine formant un îlot ,
- des moyens pour retourner ledit îlot pour que la puce de ce dernier ait sa face active vers le haut ;
- des moyens pour appliquer une matière conductrice, sur l'îlot retourné, pour matérialiser une plage de contact reliant un plot de contact de la puce au monde extérieur.

Il peut être prévu qu'un tel système puisse également comporter :
- des moyens pour appliquer une couche isolante sur tout ou partie de l'îlot retourné;
- des moyens pour découper l'îlot ,
- ou encore des moyens de commande pour mettre en oeuvre un procédé conforme à l'invention.

De même, l'invention concerne un boîtier électronique comprenant une puce ou de préférence au moins deux puces dont leur face active comporte au moins un plot de contact. Le boîtier est caractérisé en ce qu'il comprend:
- une matière enrobant les puces, l'ensemble puce(s) et matière formant un îlot ou un bloc électronique, les puces ayant leur face active orientée dans la même direction ou vers l'extérieur du boîtier;
- une matière conductrice appliquée au moins sur un plot de contact de chaque puce pour former au moins un élément de circuit électrique.

De préférence, les puces ont des dimensions différentes (hauteur, épaisseur et/ou largeur et/ou longueur) et/ ou de type différent (par exemple puce à contacts électriques ISO 7816 et puce radiofréquence).

De préférence, les puces présentent une épaisseur différente l'une par rapport à l'autre, l'épaisseur étant définie entre leur face active et face arrière opposée.

De préférence, les puces ont leur face active sensiblement au même niveau dans le bloc l'une par rapport à l'autre alors que leur face arrière n'est au même niveau dans le bloc.

De préférence, le boîtier comprend une puce nue enrobée par une matière et connectée à un composant quelconque (puce ou composant déjà emballé(e) ou enrobé par ailleurs) et emballé en outre par la même matière ci-dessus. Le procédé a ainsi l'avantage de connecter des composants de forme différentes et ou présentés à des stades de finition ou enrobage différents (déjà enrobé, partiellement ou pas du tout).

D'autres caractéristiques et avantages apparaîtront plus clairement à la lecture de la description qui suit et à l'examen des figures qui l'accompagnent parmi lesquelles :
- les figures 1 et 2 présentent un procédé de fabrication d'un boîtier électronique conforme à l'invention ;
- Les figures 3a et 3b présentent une variante prévue par l'invention pour appliquer une première couche isolante sur un îlot.

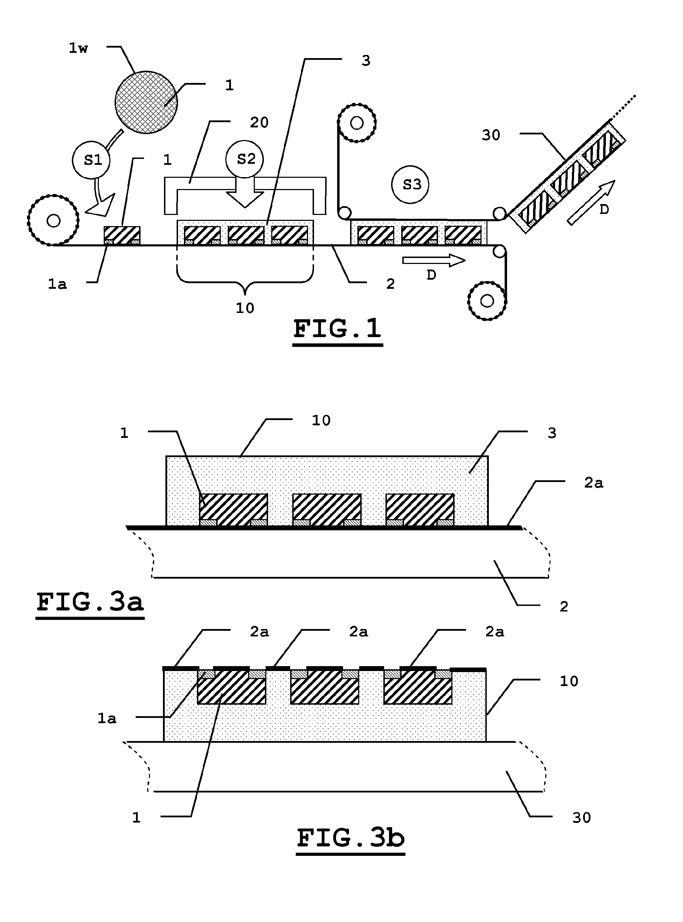

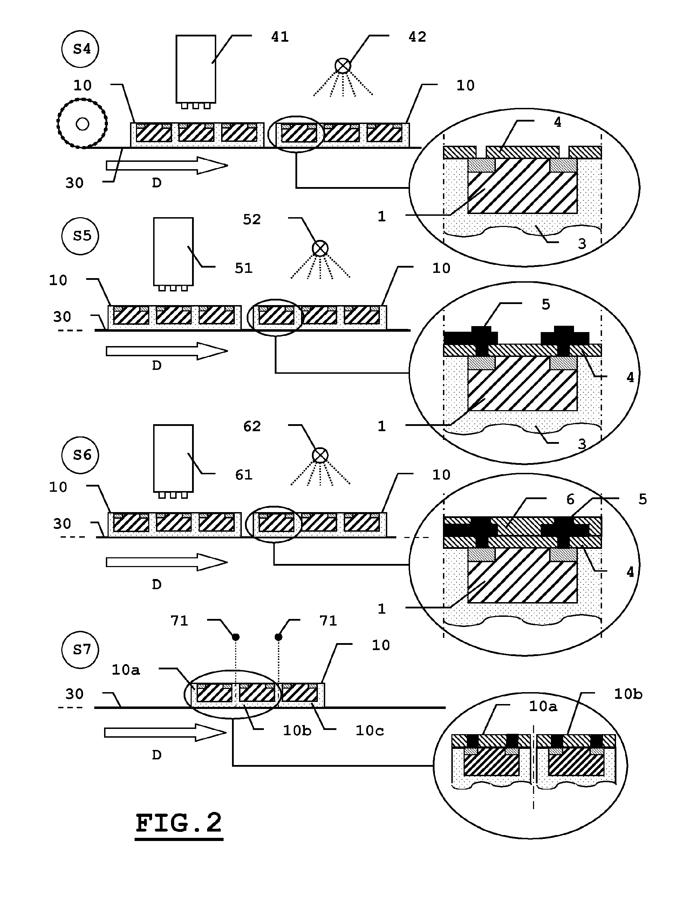

Les figures 1 et 2 présentent un système et un procédé de fabrication conformes à l'invention.

Ainsi, selon la figure 1, à partir d'une plaquette de silicium 1 W (ou *wafer* en langue anglaise) sciée comportant une pluralité de puces ayant subi une préparation permettant d'obtenir, en surface des plots de connexion, une couche conductrice inerte, une première étape S1 - d'un procédé conforme à l'invention - consiste à déposer une puce 1 (issue de la galette) sur un support adhésif 2 - tel qu'une bande adhésive. Le support 2 est préférentiellement tracté pour véhiculer la puce - comme l'indique la flèche D. La puce 1 est déposée sur le support adhésif 2, la face active de la puce dirigée vers le bas. Ainsi, ladite face active est directement en contact avec le support adhésif 2. Pour représenter une face active, la figure 1 décrit une puce 1 comportant deux plots de contact 1a visibles et présents sur ladite face active.

Outre une première fonction consistant à véhiculer une puce, l'adhésif du support 2 permet d'en assurer le maintien durant les premières étapes du procédé de fabrication. Selon un mode de réalisation préféré, le support adhésif 2 est une bande adhésive dont la largeur est de 35 ou 70 millimètres afin d'être compatible avec de nombreux équipements utilisés, selon l'état de la technique, dans l'industrie de la carte à puce.

Par ailleurs, l'invention prévoit la fabrication de boîtiers ou de modules comportant respectivement une ou plusieurs puces par boîtier ou module. Un tel dispositif peut même comporter un composant électronique tel qu'une capacité par exemple, ou un résonateur. Afin de simplifier la présentation de l'invention, nous allons décrire, tout d'abord, un premier mode de réalisation en liaison avec les figures 1 et 2, pour lequel un boîtier ne comporte qu'une seule puce 1. D'autres exemples d'applications seront décrits plus loin.

Selon ce premier exemple, une puce 1, déposée à l'étape S1, se déplace à l'aide du support adhésif 2 pour parvenir à proximité de moyens 20 prévus pour mouler une résine 3 autour de ladite puce 1. La deuxième étape S2 du procédé peut consister ainsi en un moulage-transfert d'une résine 3 appliquée autour et sur la face non active de la puce. Cette résine 3, en durcissant, apporte une protection à la puce. Elle peut constituer en outre le support voire directement le corps d'un objet électronique tel que, par exemple, une carte mini-UICC. Dans ce dernier cas, l'épaisseur de la résine 3 est dimensionnée pour satisfaire les critères dimensionnels dudit objet.

En liaison avec la figure 1, l'invention prévoit une variante pour laquelle on applique S2 une résine 3, non seulement sur une puce mais aussi sur une pluralité de puces. On obtient ainsi un ensemble « résine 3 plus puces 1 » constituant ce que nous appellerons un « îlot ». Nous verrons plus loin qu'il est possible, en fin de procédé de fabrication - par une opération de division dudit îlot - de retrouver, non pas un boîtier unique, mais un ensemble de boîtiers issus d'un même îlot. La forme de l'îlot peut ainsi être adaptée en fonction de la configuration choisie.

Le moulage appliqué sur la face non-active de la puce alors que celle-ci est positionnée sur le support 2 est particulièrement avantageux : il ne fragilise pas ladite puce. En outre, voir *supra,* après retournement de l'îlot pour exposer la face active de la puce vers le haut, cette technique de moulage permet de disposer d'îlots dont les faces actives des puces sont à fleur et au même niveau que la surface supérieure de la résine 3 formant l'îlot.

L'étape S3 d'un procédé selon l'invention consiste ainsi à retourner un îlot véhiculé par le support adhésif 2 afin que ledit îlot expose les faces actives des puces. L'invention prévoit différentes techniques pour réaliser le retournement d'îlot. Un mode de réalisation préféré consiste en S3 à utiliser un second support adhésif tracté 30 dont les propriétés d'adhésivité sont supérieures à celles du support 2. Un tel support 30 - tel que, par exemple, une bande d'une largeur comparable à la bande 2 de la figure 1 ― est appliquée sur le dos d'un îlot véhiculé par le support 2. Le contact du support 30 sur l'îlot, entraîne le détachement de ce dernier du support 2 et ainsi le retournement de l'îlot puisque ce dernier est à présent véhiculé, sur le support 30, les faces actives des puces exposées. En variante, l'invention prévoit que l'étape de retournement S3 peut consister à utiliser un outil préhenseur pour saisir un îlot véhiculé sur le support adhésif 2, le détacher de ce dernier, le retourner et le déposer, faces actives des puces exposées sur un support 30, tel qu'une bande adhésive ou un support alvéolé ou tout autre type de support apte à véhiculer un îlot ainsi retourné. Toute autre technique pour retourner un îlot pourrait également être mise en oeuvre selon l'invention.

L'invention prévoit que le support 2 puisse se présenter sous la forme d'une bande de type consommable : elle ne sert qu'à un seul passage. En variante, l'invention prévoit qu'une telle bande puissent être déroulée en début de procédé et ré-enroulée en fin d'étape S3 pour que la bande puissent être réutilisée une deuxième fois. Une bande continue pourrait également être exploitée pour peu que les propriétés adhésives de celle-ci restent suffisantes pour assurer les fonctions de maintien et de convoyage.

La figure 2 permet d'illustrer les étapes subséquentes des étapes S1, S2 et S3.

Ainsi l'invention prévoit qu'un îlot 10 soit convoyé sur un support 30 suivant une direction D. A l'étape S4, un tel îlot se présente à proximité de moyens 41 pour appliquer sur l'îlot 10 une couche de matière isolante 4. De manière préférée cette couche ne recouvre pas intégralement la surface de l'îlot 10 pour laisser au moins un plot de contact 1 a, d'une puce non recouvert par ladite couche isolante. Il est ainsi possible, par exemple, de rendre inopérant un plot de contact servant essentiellement à effectuer des tests électriques en amont du procédé de fabrication selon l'invention. A titre d'exemple, les moyens 41 peuvent consister en une tête d'impression d'une encre isolante. En variante, les moyens 41 sont aptes à réaliser un jet d'une matière isolante sur ledit îlot. Pour durcir la matière 4 déposée, on peut prévoir l'utilisation d'une lampe ou d'une diode à ultraviolets 42 pour irradier la matière 4 si celle-ci est sensible aux ultraviolets, par exemple. Toute autre technique adaptée à la matière isolante pourrait toutefois être mise en oeuvre en S4 pour fixer la couche 4. L'invention prévoit que cette étape puisse être optionnelle. Ainsi, on peut imaginer que la face active d'une puce ait déjà été traitée préalablement. L'invention prévoit également que l'étape S4 puisse être précédée d'une étape (non représentée en figure 2) pour déposer, sur la face active d'une puce 1 et/ou sur la résine 3, un primaire pour faciliter l'accroche des matières à déposer.

L'étape S5 suivante consiste à déposer une matière conductrice 5 principalement pour constituer une plage de contact en liaison avec un plot de contact 1a. Pour cela un îlot est positionné, par l'intermédiaire du support 30, à proximité de moyens 51 pour projeter ladite matière conductrice 5. Si nécessaire, cette étape peut consister à itérer plusieurs étapes de dépose de matière 5 selon l'épaisseur et/ou le motif requis. Selon un mode de réalisation préférée, les moyens 51 sont une tête d'impression - à commande numérique ou piézoélectrique - apte à imprimer une encre conductrice en tant que matière 5. Ce mode de réalisation est particulièrement avantageux car très facilement adaptable à la topographie des plots des puces. D'autres techniques d'impression digitale pourraient être utilisées pour déposer des encres conductrices comme, par exemple, le dépôt d'encre par aérosol. Optionnellement, les moyens 51 sont associés à des moyens 52 pour faire adhérer et faciliter la conductivité de la matière conductrice déposée. Ainsi les moyens 52 peuvent mettre en oeuvre une action de pression et/ou de chauffage pour entraîner la coalescence de nanoparticules contenues dans une encre conductrice 5. En variante, les moyens 52 peuvent faciliter l'évacuation d'un solvant favorisant le jet d'une encre ou matière conductrice 5 en chauffant, par exemple, un îlot ou en pulsant un air chaud sur celui-ci. L'invention prévoit l'utilisation de tous moyens adaptés pour fixer la matière conductrice 5 et favoriser la conductivité.

La figure 2 illustre une étape S6 subséquente et optionnelle permettant de déposer une deuxième couche de matière isolante 6. Pour cela, l'îlot est positionné à proximité de moyens similaires ou identiques aux moyens 41 et 42 décrits en liaison avec l'étape S4 du procédé. Cette étape permet d'isoler des pistes de connexion réalisées avec de la matière conductrice 5, pistes que l'on ne souhaite pas exposer. On permet ainsi de ne laisser apparaître que des plages de contact, affleurant la surface de l'îlot, reliées respectivement aux plots 1a de la puce 1.

L'invention prévoit qu'une étape optionnelle S7 soit mise en oeuvre pour découper un îlot. La figure 2 présente un mode de réalisation pour lequel l'îlot est positionné à proximité de lasers 71. Sous l'action d'un rayon laser l'îlot 10 est découpé précisément aux dimensions requises. En variante, dans le cas où - comme illustrée en figure 2 - un îlot comporte une pluralité de puces, cette étape S7 permet d'individualiser plusieurs sous-îlots 10a, 10b, 10c à partir de l'îlot 10. Nous pouvons de cette manière factoriser la production d'un ensemble de modules ou boîtiers pour optimiser le temps de fabrication et scinder en fin de processus lesdits modules ou boîtiers. D'autres techniques de découpe pourraient être utilisées : jet d'eau, usinage mécanique, scie à lame diamantée, etc.

L'invention prévoit, de manière préférée, que des encres puissent être utilisées pour réaliser les couches isolantes, conductrices ou le primaire d'accroche. L'utilisation de têtes d'impression, à commande numérique ou piézoélectrique, offre ainsi une très grande souplesse de mise en oeuvre et une très grande facilité d'adaptation. Les moyens 42, 52, 62 sont adaptés au type d'encre utilisée : lampe ou diode infrarouge, ultraviolet, air chaud pulsé, micro-ondes, four, etc....

L'invention prévoit, en variante, que des techniques d'impression, telles que la sérigraphie, la tampographie ou toute autre technique d'impression puissent être utilisées en complément ou en lieu et place d'un jet d'encre ou de matière.

La mise en ouvre d'un procédé et d'un système tels que décrits en liaison avec les figures 1 et 2, permet de réaliser également des modules ou boîtiers comportant plusieurs puces et/ou composants électroniques - tels que des capacités, des résonateurs, etc.

Pour réaliser de tels boîtiers, il est difficile et coûteux, à l'aide des techniques connues, de mettre en oeuvre des processus de fabrication qui soient à la fois rapides, adaptables et fiables. Il est par exemple délicat d'interconnecter, avec des fils d'or, des puces, de coller des puces dont les dimensions (notamment l'épaisseur) sont variables, de prévenir les risques de courts-circuits, etc.

L'invention supprime tous ces inconvénients et permet un processus rapide, fiable et adaptable. Ainsi, en liaison avec les figures 1 et 2, l'étape S1 peut consister à déposer, sur le support adhésif 2, un ensemble de puces et/ou de composants nécessaires à la réalisation d'un boîtier. L'adhésif du support 2 permet d'assurer la topographie des différents éléments électroniques. L'étape S1 peut également permettre de déposer une pluralité d'ensembles de composant afin de factoriser la fabrication de plusieurs boîtiers.

Une étape S2 permet de mouler dans un même îlot l'ensemble des éléments électroniques - voire une pluralité d'ensembles. Lors de l'étape de retournement S3 d'un îlot, les faces actives des puces et/ou composants électroniques sont toutes à fleur et au même niveau que la surface supérieure de la résine 3. Ainsi, les risques liés à un alignement imparfait ou défectueux de puces, à la présence de bulles d'air emprisonnées (etc.) sont supprimés. Grâce à l'invention, un îlot est parfaitement rigide et facilement reproductible. L'étape S5 d'un procédé conforme à l'invention permet, outre de matérialiser des plages de contact, de réaliser toutes les connexions entre les éléments électroniques : plus de fils d'or, moins de rebuts liés à des connexions filaires défaillantes etc. S'il est nécessaire, des étapes de dépose de couches isolantes et conductrices peuvent être répétés pour réaliser une topographie (ou *layout* en langue anglaise) complexe. Ainsi les étapes S5 et S6 peuvent être répétées autant que nécessaire pour réaliser un croisement de pistes conductrices par exemple. Selon l'invention, il peut être mis en oeuvre une étape pour élaborer une antenne connectée à une ou plusieurs éléments électroniques à l'aide des techniques telles que décrites précédemment.

Une étape de type S7 permet d'individualiser des modules ou boîtiers ainsi fabriqués. Elle peut permettre de peaufiner la découpe dudit module ou boîtier en fonction de critères normalisés stricts.

L'invention prévoit une variante de réalisation telle que présentée en liaison avec les figures 3a et 3b.

Cette technique offre une alternative à l'étape S4 décrite en liaison avec la figure 4. Ainsi, au lieu de déposer une encre isolante 4, la figure 3a décrit un support adhésif 2 comportant une fine couche de matière isolante 2a. Lors des étapes pour déposer S1 une puce et pour mouler S2 la résine 3, la matière isolante 2a est ainsi appliquée sur l'îlot.

Lors de l'étape de retournement S3, un îlot est détaché du support 2 mais la couches 2a demeure présente comme l'indique la figure 3b. Elle est ainsi transférée du support adhésif 2 à l'îlot 10. Pour conserver un plot de contact 1a (ou plusieurs) non recouvert(s) de matière 2a, l'invention prévoit qu'une partie de ladite couche isolante 2a puisse être éliminée à l'aide de diverses techniques (laser, thermiques, ultraviolets, etc.). La figure 3b présente ainsi un îlot 10 dont les plots de contact 1a des puces 1 sont ainsi dégagés.

Un tel îlot déposé sur un support 30 peut être traité par la suite selon les étapes S5 à S7 telles que décrites précédemment en liaison avec la figure 2.

Selon une autre variante, l'invention prévoit de conserver intégralement le film 2 appliqué sur les îlots et de percer celui-ci au niveau des plots de façon à disposer d'une importante couche de protection au dessus des puces ou composants.

L'invention prévoit également, pour faciliter l'étape S3 de moulage de la résine 3, d'utiliser un moule dont les parois venant en contact avec le support adhésif 2 soient traitées (par exemple à base de téflon) pour diminuer l'adhérence de ces dernières sur le support 2. En variante, le support adhésif 2 peut être démuni de matières adhésives sur des bandes extérieures afin que le moule ne vienne pas en contact avec ladite matière adhésive.

L'invention a été décrite et illustrée dans le domaine de la fabrication de modules ou boîtiers électroniques exploitées dans l'industrie des cartes à puces. L'invention ne saurait être limitée à ce seul exemple d'application mais peut s'appliquer également à d'autres domaines et technologies.

Ainsi, l'invention concerne en général un procédé pour fabriquer un boîtier électronique (10a, 10b, 10c) comprenant une puce (1) dont une face active comporte au moins un plot de contact (1a), ledit procédé étant comportant les étapes suivantes:
- fixation (S1) d'une puce (1) sur un support (2), sa face active étant orientée vers le support ;
- surmoulage (S2) d'une matière (3) sur la puce (1) pour enrober la puce sur son support (2), l'ensemble puce et résine formant un îlot ou un bloc électronique (10) ;
- retournement (S3) dudit îlot ou bloc pour que la puce (1) ait sa face active exposée vers l'extérieur ;
- application (S5) d'une matière conductrice (5) au moins sur un plot de contact (1a) de la puce pour former au moins un élément de circuit électrique.

Le support n'est pas nécessairement tracté, il peut être fourni en plaque. Les puces peuvent être fixées par tout moyen sur le support : adhésif ou moyen mécanique ou physique d'accrochage.

Le cas échéant, on s'affranchit de support adhésif, les puces étant placées sur un support ou plateau de surmoulage.

## Revendications

1. Procédé pour fabriquer un boîtier électronique (10a, 10b, 10c) comportant une puce (1) dont une face est active, ledit procédé étant **caractérisé en ce qu'**il comporte :
- une étape (S1) pour déposer une puce (1), face active vers le bas, sur un support adhésif tracté (2) ;
- une étape de moulage (S2) d'une résine (3) pour enrober la puce (1) sur son support adhésif (2), l'ensemble puce et résine formant un îlot (10) ;
- une étape de retournement (S3) dudit îlot pour que la puce (1) de ce dernier ait sa face active exposée;
- une étape pour appliquer (S5) une matière conductrice (5) sur l'îlot (10) retourné pour matérialiser une plage de contact reliant un plot de contact (1a) de la puce au monde extérieur.

2. Procédé selon la revendication 1, **caractérisé en ce que** l'îlot (10) comporte une pluralité de puces (1) et/ou de composants électroniques et **en ce que** l'étape (S5) pour appliquer une matière conductrice (5) consiste en outre à interconnecter lesdites puces et/ou composants électroniques.

3. Procédé selon l'une quelconque des revendications précédentes, **caractérisé en ce qu'**il comporte une étape (S4) - préalable à l'étape (S5) pour appliquer une matière conductrice (5) - pour appliquer une couche isolante (4) sur l'îlot retourné (10) à l'exception d'un ou plusieurs plots de contact (1a) d'une puce (1) de l'îlot.

4. Procédé selon la revendication 1 ou 2, **caractérisé en ce qu'**il comporte une étape - préalable à l'étape (S5) pour appliquer une matière conductrice (5) - pour éliminer une partie d'une couche isolante (2a) au niveau d'au moins un plot de contact (1a) d'une puce de l'îlot (10), ladite couche isolante (2a) étant préalablement transférée du support adhésif (2) à l'îlot lors des étapes pour déposer (S1) la puce et pour mouler (S2) la résine (3).

5. Procédé selon la revendication 1 ou 2, **caractérisé en ce qu'**il comporte une étape - préalable à l'étape (S5) pour appliquer une matière conductrice (5) - pour éliminer une partie du support adhésif tracté (2) - formant une couche isolante - au niveau d'au moins un plot de contact (1a) d'une puce de l'îlot (10), ledit support adhésif (2) demeurant appliqué à l'îlot à l'issue des étapes pour déposer (S1) la puce et pour mouler (S2) la résine (3).

6. Procédé selon l'une quelconque des revendications précédentes, **caractérisé en ce qu'**il comporte une étape (S6) - subséquente à l'étape (S5) pour appliquer une matière conductrice (5) - pour appliquer une couche isolante (6) sur l'îlot retourné (10) à l'exception d'au moins une plage de contact de l'îlot.

7. Procédé selon l'une quelconque des revendications précédentes, caractérisé en qu'il comporte une étape - subséquente à l'étape (S4) pour appliquer une première couche isolante (2a, 4) - pour appliquer, sur l'îlot retourné, une matière conductrice pour matérialiser une antenne connectée à au moins une plage de contact de l'îlot.

8. Procédé selon l'une quelconque des revendications précédentes, caractérisé en que l'étape de retournement (S3) de l'îlot (10) consiste à appliquer sur l'îlot un second support adhésif (30) tracté pour détacher l'îlot du premier support adhésif (2).

9. Procédé selon l'une quelconque des revendications 1 à 7, caractérisé en que l'étape de retournement (S3) de l'îlot consiste à mettre en oeuvre un dispositif préhenseur pour détacher l'îlot du support adhésif (2) et déposer ce dernier sur un second support tracté (30).

10. Procédé selon l'une quelconque des revendications précédentes, **caractérisé en ce qu'**il comporte une étape de découpe (S7) de l'îlot pour adapter les dimensions de ce dernier.

11. Procédé selon l'une quelconque des revendications 1 à 9 **caractérisé en ce qu'**il comporte une étape de découpe (S7) de l'îlot pour diviser ledit îlot en sous-îlots (10a, 10b, 10c) individualisés.

12. Procédé selon l'une quelconque des revendications précédentes **caractérisé en ce qu'**il comporte une étape préalable pour déposer sur un plot de contact (1a) d'une puce, un matériau pour faciliter la conductivité entre ledit plot et la matière conductrice (5) prochainement déposée.

13. Procédé selon l'une quelconque des revendications précédentes, **caractérisé en ce que** l'étape (S4, S6) pour appliquer une couche isolante (4, 6) consiste à mettre en oeuvre une irradiation (42) de la couche isolante appliquée sur l'îlot pour rigidifier ladite couche.

14. Procédé selon l'une quelconque des revendications précédentes, **caractérisé en ce que** l'étape (S5) pour appliquer une matière conductrice (5) consiste à déposer une encre nécessitant, après son dépôt (51), une étape de coalescence (51) - si l'encre comporte des nanoparticules - ou une étape (51) pour évacuer un solvant - si ce dernier est présent dans l'encre - ou encore, une étape (51) pour irradier l'encre si cette dernière est sensible aux ultraviolets.

15. Système pour fabriquer un boîtier électronique comportant une puce dont une face est active, ledit système étant **caractérisé en ce qu'**il comporte :
- des moyens pour déposer une puce (1) - face active vers le bas - sur un support adhésif tracté (2) ;
- des moyens pour mouler (20) une résine (3) pour enrober la puce (1) sur son support adhésif (2), l'ensemble puce et résine formant un îlot (10) ;
- des moyens (30) pour retourner ledit îlot pour que la puce (1) de ce dernier ait sa face active vers le haut ;
- des moyens pour appliquer (51, 52) une matière conductrice (5), sur l'îlot retourné, pour matérialiser au moins une plage de contact reliant un plot de contact (1a) de la puce au monde extérieur.

16. Boîtier électronique (10a, 10b, 10c) comprenant au moins une ou deux puces (1) dont leur face active comporte au moins un plot de contact (1a), **caractérisé en ce qu'**il comprend:
- une matière (3) enrobant les puces, l'ensemble puce (s) et matière formant un îlot ou un bloc électronique (10), chaque puce (1) ayant sa face active orientée dans la même direction;
- une matière conductrice (5) appliquée au moins sur un plot de contact (1a) de chaque puce pour former au moins un élément de circuit électrique.

17. Boîtier électronique (10a, 10b, 10c) selon la revendication 16, **caractérisé en ce que** la matière conductrice est réalisée par jet de matière ou jet d'encre conductrice.

18. Boîtier électronique (10a, 10b, 10c) selon la revendication 16, **caractérisé en ce que** les puces ont des épaisseurs différentes entre elles, l'épaisseur étant définie entre leur face active et face arrière opposée.
